# EUROPÄISCHE PATENTSCHRIFT

(11) **EP 3 532 365 B1**
(45) Veröffentlichungstag und Bekanntmachung des Hinweises auf die Patenterteilung: **25.08.2021**
(21) Anmeldenummer: 18745938.3
(22) Anmeldetag: 25.07.2018
(51) Int. Cl.: B62D 25/00

(54) **KAROSSERIETEIL UND VERFAHREN ZUM HERSTELLEN EINES KAROSSERIETEILS**
VEHICLE BODY PART AND METHOD FOR PRODUCING A VEHICLE BODY PART
ÉLÉMENT DE CARROSSERIE ET PROCÉDÉ DE FABRICATION D'UN ÉLÉMENT DE CARROSSERIE

(30) Priorität: 26.07.2017 EP 17183350
(43) Veröffentlichungstag der Anmeldung: 04.09.2019
(73) Patentinhaber: Sono Motors GmbH, 80935 München (DE)
(72) Erfinder: CHRISTIANS, Jona, 80809 München (DE); HAHN, Laurin, 81373 München (DE)
(74) Vertreter: Qip Patentanwälte Dr. Kuehn & Partner mbB
(86) Internationale Anmeldenummer: PCT/EP2018/070232
(87) Internationale Veröffentlichungsnummer: WO 2019/020718

(56) Entgegenhaltungen:
- EP-A2- 1 245 418
- CN-A- 103 387 011
- CN-A- 103 387 011
- DE-A1- 19 714 083
- DE-A1-102010 013 784
- DE-U1- 8 813 137
- GB-A- 2 437 946
- JP-A- 2012 104 626
- JP-A- 2012 222 215
- JP-A- 2016 207 849
- JP-A- 2017 092 067

## Beschreibung

Die Erfindung betrifft ein Karosserieteil eines Kraftfahrzeugs, insbesondere ein Karosserieteil eines Personenkraftwagens. Weiterhin betrifft die Erfindung Verfahren zum Herstellen eines Karosserieteils eines Kraftfahrzeugs. Die Erfindung kann sich zudem auf ein Kraftfahrzeug mit einem oder mehreren solcher Karosserieteile beziehen.

Kraftfahrzeuge weisen häufig eine sogenannte selbsttragende Karosserie auf. Dabei haben jeweilige eine Außenkontur des Kraftfahrzeugs bildende Karosserieteile zugleich eine strukturell tragende Funktion. Dadurch kann auf eine zusätzliche, tragende Rahmenkonstruktion, wie beispielsweise jeweilige Verkleidungselemente haltende Rohre, verzichtet werden. In einer solchen selbsttragenden Karosserie können jedoch jeweilige Solarzellen zum Versorgen eines Energiesystems des Kraftfahrzeugs nur schwierig integriert werden, insbesondere da Solarzellen normalerweise spröde sind und/oder nur geringe strukturelle Belastungen ohne Beschädigung tragen können. Üblicherweise werden Solarzellen deswegen lediglich nachträglich an selbstragende Karosserien, beispielsweise in Form von planen Panels, angebaut. Da selbsttragende Karosserien häufig auch eine gekrümmte Außenkontur aufweisen, stehen jeweilige Solarpanels bei einer solchen Integration meist von jeweiligen Karosserieteilen ab und beeinflussen die Aerodynamik des Kraftfahrzeugs nachteilig.

Bei einer klassischen Karosseriekonstruktion mit einem Aufbau, bei welchem jeweilige Verkleidungselemente der Karosserie an einem strukturell tragenden Rahmen befestigt sind, kann eine Integration von Solarzellen ebenfalls aufwendig sein. Hier sind beispielsweise die Solarzellen außenseitig an den Verkleidungsteilen zu befestigen. Auch hierbei können die jeweiligen Solarzellen dann von der Außenkontur des Kraftfahrzeugs abstehen und die Aerodynamik des Kraftfahrzeugs nachteilig beeinflussen.

Die Integration von Solarzellen in die Karosserie von Kraftfahrzeugen ist meist auch relativ teuer, wobei sich auch der Austausch der Solarzellen unter Umständen schwierig gestaltet (etwa bei deren Beschädigung).

Die JP 2017 092067 A offenbart ein Karosserieteil gemäß dem Oberbegriff des Patentanspruchs 1.

In EP 1 245 418 A2 und DE 88 13 137 U1 werden herkömmliche Ansätze beschrieben, bei denen Solarzellen an Teilen einer Fahrzeugkarosserie vorgesehen werden.

Aufgabe der vorliegenden Erfindung ist es, ein Karosserieteil für ein Kraftfahrzeug zu schaffen, bei welchem jeweilige Solarzellen besonders vorteilhaft integriert sind. Weiterhin ist es Aufgabe der vorliegenden Erfindung, ein Verfahren zum Herstellen eines Karosserieteils zu schaffen, bei welchem eine Solarzelle besonders vorteilhaft integriert ist.

Diese Aufgaben werden erfindungsgemäß durch die Gegenstände der unabhängigen Patentansprüche gelöst. Vorteilhafte Ausgestaltungen mit zweckmäßigen Weiterbildungen der Erfindung sind in den jeweiligen Unteransprüchen angegeben, wobei vorteilhafte Ausgestaltungen des Karosserieteils als vorteilhafte Ausgestaltungen des Herstellungsverfahrens und umgekehrt anzusehen sind.

Ein erster Aspekt der Erfindung betrifft ein Karosserieteil eines Kraftfahrzeugs gemäß Patentanspruch 1 mit wenigstens einem Rahmenbauteil und wenigstens einem daran angeordneten Verkleidungsteil. Das Verkleidungsteil weist wenigstens eine im Wesentlichen luftdicht und im Wesentlichen wasserdicht verschlossene Aussparung mit mehreren darin angeordneten Solarzellen zum Erzeugen einer elektrischen Energie auf. Die Außenseite des Verkleidungsteils weist wenigstens in einem Bereich benachbart zu einer der Solarzellen eine dreidimensional gekrümmte Außenform auf, welche so ausgebildet ist, dass sie in Einbaulage an dem Kraftfahrzeug einen Teil einer Fahrzeugaußenkontur bildet.

Das Verkleidungsteil weist eine Vielzahl von Solarzellen auf. Wenigstens eine, mehrere oder alle dieser Solarzellen sind im Wesentlichen plan.

Das Kraftfahrzeug hat vorzugsweise eine dreidimensional gekrümmte Fahrzeugaußenkontur. Das Verkleidungsteil bildet in Einbaulage am Kraftfahrzeug vorzugsweise einen Teil dieser dreidimensional gekrümmten Fahrzeugaußenkontur. Dabei bilden jeweilige Solarzellen in jeweiligen Aussparungen vorzugsweise keine Kanten oder abstehende Teile auf der Außenhaut des Kraftfahrzeugs. Die Aerodynamik des Karosserieteils mit integrierten Solarzellen kann so besonders günstig sein. Im Bereich des Verkleidungsteils mit dreidimensional gekrümmter Außenform kann ein Krümmungsradius der Außenform mindestens 10 cm, mindestens 20, oder mindestens 30 cm betragen. Optional können alle Krümmungsradien der dreidimensional gekrümmten Außenform in diesem Bereich mindestens 10 cm, mindestens 20, oder mindestens 30 cm betragen. Besonders bevorzugt betragen jeweilige Krümmungsradien der dreidimensional gekrümmten Außenform in diesem Bereich mindestens 60 cm, mindestens 70, oder mindestens 80 cm.

Die Außenseite des Karosserieteils kann durch eine Einbaulage an dem Kraftfahrzeug definiert sein, wobei die Außenseite in Einbaulage vorzugsweise vom Fahrzeug nach außen weist. Alternativ oder zusätzlich kann die Außenseite des Karosserieteils auch durch die jeweiligen Solarzellen definiert sein. Die Außenseite des Karosserieteils ist in diesem Fall vorzugsweise diejenige Seite, von der die Solarzellen durch von außen einfallendes Sonnenlicht zum Erzeugen von elektrischer Energie anregbar sind. Vorzugsweise ist die Außenseite des Karosserieteils einem Innenraum des Kraftfahrzeugs in Einbaulage abgewandt.

Damit einfallendes Licht die Solarzellen gut erreicht, kann eine Außenseite des Verkleidungsteils wenigstens teilweise transparent ausgebildet sein, insbesondere im Bereich der wenigstens einen Aussparung und/oder über der bzw. den Solarzellen. Jeweilige Aussparungen können als Hohlraum in dem Verkleidungsteil ausgebildet sein. Die eine oder die mehreren Solarzellen können in der Aussparung verkapselt sein.

Dadurch, dass die Aussparung im Wesentlichen wasserdicht und/oder luftdicht verschlossen ist, können die jeweiligen Solarzellen vor äußeren Umwelteinflüssen geschützt sein.

Das Verkleidungsteil weist vorzugsweise eine oder mehrere elektrische Anschlüsse zur Anbindung und/oder Steuerung der Solarzellen auf. Diese Anschlüsse sind vorzugsweise nicht an der Außenseite des Verkleidungsteils vorgesehen. Entsprechende Anschlüsse können beispielsweise an einer dem Innenraum zugewandten Innenseite des Verkleidungsteils und/oder entlang eines äußeren Rands des Verkleidungsteils, der die Innenseite und die Außenseite verbindet, vorgesehen sein. Durchgänge für elektrische Anschlüsse können beispielsweise auf einer dem Innenraum zugewandten Seite einen Zugang zu dem Innenraum der Aussparung bilden. Diese Durchgänge sind vorzugsweise wasserdicht und/oder luftdicht. Dies ist jedoch nicht zwingend, da ein Eindringen von Feuchtigkeit und dergleichen auch durch die im Wesentlichen geschlossene Außenhaut des Kraftfahrzeugs und/oder jeweilige Verkleidungselemente des Innenraums verhindert werden könnte. Es können an solchen Durchgängen aber auch jeweilige Dichtungen vorgesehen werden, so dass beispielsweise elektrische Leitungen von den Solarzellen zu einem Energiespeicher des Kraftfahrzeugs kein Eindringen von Wasser in den Innenraum der Aussparung ermöglichen. Unter Umständen kann eine die Solarzelle umgebende Folie und/oder Masse, insbesondere eine Kunststofffolie oder Kunststoffmasse, bereits selbst eine ausreichende Abdichtung von bei der Herstellung des Karosserieteils vorgesehenen Leitungen bereitstellen.

Es kann vorgesehen sein, dass mehrere Solarzellen in einer jeweiligen Aussparung gemeinsam angeordnet sind. Alternativ kann es auch vorgesehen sein, dass pro Solarzelle eine im Wesentlichen geschlossene Aussparung vorgesehen ist. Bei mehreren Solarzellen pro Aussparung ist das Verkleidungsteil besonders kostengünstig herstellbar. Durch die Anordnung der Solarzellen in mehreren separaten Aussparungen oder gar jeder Solarzelle in einer separaten Aussparung können, auch wenn die Dichtigkeit einer Aussparung kompromittiert wurde, beispielsweise durch einen Zusammenprall mit einem Hindernis, andere Solarzellen weiterhin vor Umwelteinflüssen geschützt bleiben. Durch eine Bauweise mit einer Vielzahl von Aussparungen, in welchen jeweils eine Vielzahl von Solarzellen angeordnet ist, können Herstellungskosten und Robustheit des Verkleidungsteils bezüglich des Schutzes der Solarzellen optimiert werden.

Das Rahmenbauteil ist das wesentlich strukturell tragende Bauteil des Karosserieteils, welches das Verkleidungsteil trägt und abstützt, insbesondere in Einbaulage am Kraftfahrzeug. Das Verkleidungsteil hat einen im Vergleich wesentlich kleineren strukturell tragenden Anteil. Beispielsweise können jeweilige Lasten zu 70%, 90% oder mehr von dem Rahmenbauteil aufgenommen werden und zu lediglich 30%, 10% oder weniger von dem Verkleidungsteil. Durch eine entsprechende Verbindung des Verkleidungsteils mit dem Rahmenbauteil und/oder eine entsprechende Werkstoffauswahl für das Verkleidungsteil kann es jedoch auch vorgesehen sein, dass das Verkleidungsteil höhere strukturelle Lasten aufnehmen kann. Das Karosserieteil kann nach Art einer selbsttragenden Karosserie ausgebildet sein. Das Rahmenbauteil kann beispielsweise Teil einer Rahmenkonstruktion des Kraftfahrzeugs sein. Das Rahmenbauteil kann dreidimensional gekrümmt sein und unter Umständen ebenfalls einen Teil der Außenkontur des Kraftfahrzeugs bilden. Insbesondere kann eine Außenfläche des Rahmenbauteils eine dreidimensional gekrümmte Außenform aufweisen, welche so ausgebildet ist, dass sie in Einbaulage an dem Kraftfahrzeug einen weiteren Teil der Fahrzeugaußenkontur bildet. Das Rahmenbauteil kann beispielsweise als eine dreidimensional gekrümmte Stahl-, Aluminium-, GFK- oder CFK-Konstruktion ausgebildet sein. Bei dem hier beschriebenen Karosseriebauteil kann anstelle von CFK (Kohlefaserverstärkter Kunststoff) auch immer GFK (Glasfaserverstärkter Kunststoff) als Werkstoff verwendet werden. Die Festigkeit von CFK ist besonders hoch und sein Gewicht besonders gering, GFK ist im Vergleich kostengünstiger.

Das Verkleidungsteil und das Rahmenbauteil können beispielsweise miteinander verklebt sein. Der Kleber und/oder eine jeweilige Klebefuge können dabei so ausgelegt sein, dass sie unterschiedliche thermische Ausdehnungen des Rahmenbauteils und des Verkleidungsteils kompensieren können, insbesondere aufgrund der Verwendung unterschiedlicher Werkstoffe.

Das Karosserieteil, insbesondere das Verkleidungsteil, kann an einer in Einbaulage dem zur Energieerzeugung einfallenden Sonnenlicht abgewandten Seite farbig lackiert sein. Diese Seite kann auch als Innenseite des Verkleidungsteils bezeichnet werden und/oder einer dem Innenraum des Kraftfahrzeugs zugewandten Seite entsprechen. Es kann also beispielsweise eine dem Innenraum zugewandte Seite des Verkleidungsteils farbig lackiert sein. Dadurch kann das Kraftfahrzeug von außen farbig lackiert wirken, während trotzdem Sonnenlicht zur Energieerzeugung in die Solarzellen einfallen kann. Alternativ können auch jeweilige eingefärbte Folien vorgesehen sein, um dem Kraftfahrzeug eine bestimmte Farbe zu geben. Auch das Rahmenbauteil kann farbig lackiert sein oder mit einer farbigen Folienschicht bedeckt sein. Eine Lackierung und/oder Folierung des Rahmenbauteils kann dieses auch gut vor Beschädigungen, wie beispielsweise Kratzern, schützen.

Eine Außenseite des Karosserieteils, insbesondere eine Außenseite des Verkleidungsteils, kann mit einer Klarlackschicht lackiert sein, vorzugsweise wenigstens im Bereich jeweiliger Solarzellen und/oder jeweiliger Aussparungen. Diese Klarlackschicht kann auch als Hardcoating bezeichnet werden. Dadurch wird einfallendes Sonnenlicht nicht oder nur zu einem geringen Anteil blockiert, während gleichzeitig eine glatte, robuste und/oder einheitliche Oberfläche des Verkleidungsteils an der Fahrzeugaußenkontur und/oder der Fahrzeugaußenhaut geschaffen werden kann. Vorzugsweise ist das Hardcoating bereits auf jeweilige Elemente des Verkleidungsteils aufgebracht, bevor diese verformt werden.

Eine dreidimensional gekrümmte Außenform und/oder Außenkontur kann eine dreidimensional gekrümmte Fläche sein. Insbesondere kann diese dreidimensional gekrümmte Form einen stetigen Verlauf aufweisen. Die dreidimensional gekrümmte Form kann frei von Kanten, Absätzen und/oder spitzen Winkeln sein.

Wie bereits beschrieben, kann das Verkleidungsteil des erfindungsgemäßen Karosserieteils eine Außenseite, eine Innenseite und einen die Außenseite und die Innenseite verbindenden Rand aufweisen, wobei vorzugsweise zumindest die Außenseite dreidimensional gekrümmt ist. Die Fläche der Außenseite ist vorzugsweise größer als die Fläche des Rands, vorzugsweise mindestens um den Faktor fünf, mindestens um den Faktor zehn, oder mindestens um den Faktor fünfzig.

Die obigen Ausgestaltung des Karosserieteils bietet auch den Vorteil, dass sowohl ein Rahmenbauteil als auch ein Verkleidungsteil eine frei geformte Außenkontur aufweisen kann, wodurch ein besonders aerodynamisch vorteilhaftes Kraftfahrzeug geschaffen werden kann, während in jeweiligen Aussparungen Solarzellen aufgenommen werden können, welche eine standardisierte Form aufweisen und/oder wenigstens teilweise vormontiert sind. Dadurch können diese Solarzellen besonders kostengünstig hergestellt oder beschafft werden, während es dennoch zu keinen oder nur geringfügigen Einschränkungen bei der Gestaltung der Außenkontur des Kraftfahrzeugs kommt. Insbesondere können die Solarzellen im Wesentlichen unflexible und/oder steife und/oder flache Solarpaneele sein. Diese können einfach in der Karosserie des Kraftfahrzeugs integriert werden, während die Außenkontur dennoch im Wesentlichen frei gestaltet werden kann.

Vorzugsweise weist das Verkleidungsteil eine Vielzahl von im Wesentlichen planen Solarzellen auf, welche elektrisch miteinander verbunden sind (z. B. mindestens 5, mindestens 10, mindestens 20, oder mindestens 30 separate Solarzellen). Dadurch können kostengünstige Standardsolarzellen und/oder vormontierte Solarzellen verwendet werden und gleichzeitig die zur Verfügung stehende Außenfläche des Kraftfahrzeugs zu einem besonders großen Anteil von Solarzellen genutzt werden. Außerdem können jeweilige Solarzellen so besser an einen Verlauf des Rands des Verkleidungsteils angepasst werden. Zudem kann das Verkleidungsteil so besonders flach sein, da jeweilige Aussparungen so nur eine geringe Krümmung der Außenkontur durch ihre jeweilige Höhe quer zu einer Längserstreckungsrichtung des Verkleidungsteils im Bereich jeder einzelnen Solarzelle kompensieren müssen. Beispielsweise können so auch jeweilige einzelne Solarzellen in einer Richtung quer zu einer Haupterstreckungsebene des Verkleidungsteils zueinander versetzt sein, um durch diesen Versatz einer Krümmung der Außenkontur des Kraftfahrzeugs wenigstens teilweise zu folgen. Das Verkleidungsteil kann dabei beispielsweise auch mehrere Strings von Solarzellen aufweisen, welche bereits vor dem Einbringen in jeweilige Aussparungen elektrisch miteinander verbunden sind. Diese jeweiligen Strings von Solarzellen können dabei jeweils in einer gemeinsamen zugeordneten Aussparung angeordnet sein. Die Strings sind so besonders einfach zu montieren.

Vorzugsweise schließt die Außenseite des Verkleidungsteils im Wesentlichen bündig an die Außenseite des Rahmenbauteils an. Eine solche Bauweise ist aerodynamisch besonders vorteilhaft und ermöglicht einen besonders harmonischen Gesamteindruck der Außenkontur des Kraftfahrzeugs.

Vorzugsweise umfasst das Verkleidungsteil ein wenigstens bereichsweise gemäß der gekrümmten Außenform und/oder gemäß der gekrümmten Fahrzeugaußenkontur gekrümmtes Trägerelement, in oder an welchem die wenigstens eine Solarzelle angeordnet ist. Das wenigstens eine Trägerelement des Verkleidungsteils kann aus einem Kunststoff gebildet sein, z. B. einem transparenten Kunststoff. In Frage kommt beispielsweise Polycarbonat. Polycarbonat kann in vorteilhafter Weise einfach geformt werden und ist zudem ein guter Isolator gegen elektrischen Strom. Gegebenenfalls kann darauf verzichtet werden, die Solarzellen und/oder jeweilige elektrische Leitungen zusätzlich elektrisch zu isolieren. Das Trägerelement kann insbesondere eine strukturell tragende Funktion für jeweilige Solarzellen übernehmen. Zu diesem Zweck können ein oder mehrere Trägerelemente die jeweiligen Aussparungen des Verkleidungsteils bilden, an welchen die jeweiligen Solarzellen befestigbar sind.

Das Trägerelement weist vorzugsweise mindestens ein strukturell tragendes Trägerbauteil auf, beispielsweise mindestens eine Scheibe. Vorzugsweise ist das Trägerelement durch mindestens zwei Scheiben gebildet, wobei eine äußere der Scheiben die Außenseite des Verkleidungsteils bildet und eine innere der Scheiben eine der Außenseite abgewandte Innenseite, wobei die Aussparung zwischen den zwei Scheiben ausgebildet ist. So können jeweilige Aussparungen besonders einfach in dem Verkleidungsteil gebildet werden. Zudem kann es so möglich sein, die jeweiligen Scheiben zur Ausbildung einer Aussparung nur geringfügig zu verformen.

Die Scheibe/n können als Platten ausgebildet sein und/oder aus ebenen Platten geformt werden. Insbesondere können eine Scheibe oder beide Scheiben hergestellt werden, indem ein jeweiliges planes Element (und/oder eine jeweilige plane Platte) durch einen Verformungsprozess gewölbt wird. Vorzugsweise werden beide Scheiben aus planen Platten hergestellt, die zur Herstellung des Trägerelements gewölbt werden. Die Scheiben können aus einem Polycarbonatwerkstoff gebildet sein und können somit auch als Polycarbonatscheiben bezeichnet werden. Die jeweiligen Polycarbonatscheiben können dabei eine Dicke von beispielsweise weniger als 5 mm aufweisen, vorzugsweise von 2,5 mm oder weniger. Jeweilige Scheiben (z. B. Polycarbonatscheiben) können dabei auch eingefärbt sein, insbesondere eine einer jeweiligen Sonnenlichteinstrahlung abgewandte Scheibe (z.B. Polycarbonatscheibe). Alternativ können jeweilige Scheiben (z.B. Polycarbonatscheiben) auch mit einem farbigen Hardcoating versehen sein. Es können auch andere Materialien als Polycarbonat verwendet werden, z. B. Glas.

Das Karosseriebauteil kann unterschiedliche Materialien je nach Einsatzort aufweisen. Insbesondere können an einem Fahrzeug mehrere erfindungsgemäße Karosseriebauteile vorgesehen sein, wobei diese Karosseriebauteile - insbesondere deren jeweiliges Rahmenbauteil - je nach Einsatzort aus mindestens zwei verschiedenen Werkstoffen hergestellt sein können. Das Fahrzeug kann somit ein erstes Rahmenbauteil aufweisen, dass aus einem ersten aus der folgenden Gruppe ausgewählten Werkstoff ausgebildet ist: dreidimensional gekrümmte Stahl-, Aluminium-, GFK- oder CFK-Konstruktion. Ferner kann das Fahrzeug ein zweites Rahmenbauteil aufweisen, dass aus einem zweiten aus dieser Gruppe ausgewählten Werkstoff ausgebildet ist, wobei der zweite Werkstoff verschieden vom ersten Werkstoff ist.

Vorzugsweise sind die zwei Scheiben über einen Abstandshalter miteinander verbunden, beispielsweise mit einem doppelseitigen Acrylklebeband. Der Abstandshalter (etwas das Acrylklebeband) kann der Fixierung der jeweiligen Scheiben aneinander dienen, insbesondere während der Herstellung des Verkleidungsteils, aber auch als eine Abdichtung für eine jeweilige Aussparung entlang des umlaufenden Rands des Verkleidungsteils. Die Scheiben des Trägerelements können wenigstens bereichsweise aneinander anliegen und/oder aneinander angrenzen. Beispielsweise kann ein Rand der jeweiligen Scheiben um die Aussparung herum aneinander anliegen und diese so begrenzen.

Ein Freiraum zwischen der wenigstens einen Solarzelle und jeweiligen die zugeordnete Aussparung begrenzenden Wandungen des Verkleidungsteils kann mit einem Silikongel gefüllt sein. Dafür können die jeweiligen Aussparungen mittels Acryl, insbesondere doppelseitigem Acrylklebeband, abgedichtet sein. Mittels des Silikongels können die Solarzellen verkapselt werden, um sie besonders gut vor Umwelteinflüssen zu schützen. Gleichzeitig kann das Silikongel im Wesentlichen lichtdurchlässig sein, so dass eine Effizienz der Solarzellen nicht oder nur wenig beeinträchtigt wird. Das Silikongel kann insbesondere ein Eindringen von Luft und/oder Wasser in die Aussparung des Verkleidungsteils verhindern und Erschütterungen dämpfen. Silikongel kann auch als Abdichtung der Aussparungen verstanden und/oder verwendet werden.

Die Aussparung kann durch eine oder mehrere an dem Trägerelement angeordnete Folien, insbesondere thermoplastische Folien (etwa Polyurethanfolien), begrenzt sein, welche zum Abdichten der Aussparung einen Hohlraum begrenzend verschlossen sind und/oder miteinander verbunden sind. Geeignete Folienmaterialien sind beispielsweise PTFE, ETFE, vernetzte und unvernetzte thermoplastische Elastomere (TPE), Elastomere, Ethylen-Vinylacetat-Copolymere (EVA), Zweikomponenten-Silikone, thermoplastische Polyurethane (TPU), thermoplastische Olefine (TPO), Polyvinylbutyral (PVB), thermoplastische Silikon-Elastomere (TPSE), Ionomere und modifiziertes Polyolefin. Die Begrenzung der Aussparung durch die Folie kann dabei auch nur bereichsweise sein. Eine thermoplastische Polyurethanfolie kann auch als TPU-Folie bezeichnet werden.

Mittels jeweiliger Folien, insbesondere mittels jeweiliger Kunststofffolien, können jeweilige Aussparungen des Verkleidungsteils besonders gut abgedichtet werden. Die Abdichtung kann mittels solcher Folien zusätzlich oder alternativ zu Acrylklebestreifen erfolgen. Insbesondere können die Solarzellen auch zwischen Folien, insbesondere zwischen zwei TPU-Folien, verkapselt sein, vorzugsweise mittels zweier verschweißter Folien. Eine jeweilige Folie kann jedoch auch direkt auf ein entsprechendes Träger-(etwa eine entsprechende Scheibe) oder Rahmenbauteil appliziert werden. Somit kann die Folie selbst die Außen- oder Innenseite des Verkleidungsteils bilden, während das Träger- oder Rahmenbauteil die gegenüberliegende Innen- bzw. Außenseite bildet. Die eine oder die mehreren Folien können hierbei ein nicht strukturell tragendes Teil bilden, das durch ein strukturell tragendes Bauteil, insbesondere das Trägerbauteil (d.h. die mindestens eine Scheibe), gestützt werden kann. Die Folie kann im eingebauten Zustand das Rahmen- und/oder Trägerbauteil in Richtung der Außenseite der Karosserie bedecken. Dabei kann die Aussparung durch die Folie nach außen verschlossen sein. Alternativ kann die Folie das Rahmen- und/oder Trägerbauteil in Richtung der Innenseite der Karosserie bedecken. Dabei kann die Aussparung durch die Folie nach innen verschlossen sein.

Die jeweiligen Folien können dabei auch dazu genutzt werden, die zwei Scheiben des Trägerelements miteinander zu verbinden. Beispielsweise können eine oder mehrere TPU-Folien zwischen zwei Polycarbonatscheiben angeordnet werden und durch Erhitzung so weit aufschmelzen, dass diese zwei Scheiben fest miteinander verbunden sind. Alternativ oder zusätzlich kann eine Folie, insbesondere in Einbaulage des Karosseriebauteils außenseitig angeordnete Folie, auch einer der Scheiben ersetzen.

Vorzugsweise weist das Rahmenbauteil einen Aufnahmebereich mit einer Stufe auf, wobei das Verkleidungsteil in dem Aufnahmebereich angeordnet ist. An einer Stufe kann das Verkleidungsteil besonders sicher gehalten sein. Dabei kann die Stufe auch konstruktiv einfach ermöglichen, dass eine Außenseite des Rahmenbauteils bündig an einer Außenseite des Verkleidungsteils anschließt. Gleichzeitig kann eine Stufe besonders einfach eine Dehnungsfuge für die Kompensation unterschiedlicher thermischer Ausdehnungskoeffizienten bereitstellen. Vorzugsweise ist das Verkleidungsteil an der Stufe gehalten, insbesondere an einer innenseitigen Auflagefläche benachbart zur Innenseite des Verkleidungsteils. Das Rahmenbauteil kann so einen Halterahmen bilden, wobei dieser Halterahmen zumindest teilweise gefräst und/oder aus CFK oder GFK gebildet sein kann. Das Rahmenbauteil kann das Verkleidungsteil zumindest abschnittsweise (etwa bezogen auf eine Länge des Rands des Verkleidungsteils über mindestens 50%, mindestens 70% oder mindestens 90% der Länge) einfassen oder sogar außenseitig komplett umlaufend einfassen, beispielsweise nach Art eines Bilderrahmens. Der Aufnahmebereich kann beispielsweise als Aufnahmeöffnung, Durchgangsöffnung, Vertiefung und/oder Aussparung ausgebildet sein. Der Rahmen, insbesondere der Aufnahmebereich, kann eine zumindest abschnittsweise oder vollständig durchgängige Rückwand und/oder Verstrebungen aufweisen. Das Verkleidungsteil kann entlang seiner Innenseite an dieser Rückwand und/oder an diesen Verstrebungen zusätzlich abgestützt sein, etwa über einen Moosgummi.

Vorzugsweise ist die Stufe des Rahmenbauteils im Wesentlichen Z-förmig ausgebildet, wobei ein oberer Schenkel der Z-förmigen Stufe die Außenseite des Rahmenbauteils bildet, welche sich im Wesentlichen bündig an das Verkleidungsteil anschließen kann, und wobei ein unterer Schenkel der Stufe eine Auflagefläche für das Verkleidungsteil bildet. Die Z-Form hat vorzugsweise jeweils einen Innenwinkel von 90°, das heißt, sie ist in Form eines doppelten Ls ausgebildet. Eine solche Form ist besonders kostengünstig zu fertigen. Die Z-Form kann aber auch davon abweichende Winkel aufweisen, um die Stufe besonders gut an eine Krümmung der Außenkontur anzupassen. Die Auflagefläche kann insbesondere zum Halten des Verkleidungsteils dienen. Ein den oberen und den unteren Schenkel verbindender Schenkel kann eine seitliche Begrenzung der Aufnahmeöffnung des Rahmens bilden, in welcher das Verkleidungsteil angeordnet ist. Der untere Schenkel und/oder der den unteren und den oberen Schenkel verbindende Schenkel können als Fixierflächen, insbesondere Klebeflächen, zum Fixieren des Verkleidungsteils am Rahmenbauteil dienen. Ein jeweiliger Freiraum zwischen den Schenkeln der Stufe und dem Verkleidungsteil kann dabei mit einer Verklebung aufgefüllt werden, welche insbesondere eine Kompensation unterschiedlicher thermischer Dehnungen kompensieren kann, z. B. mittels Acryl. Alternativ oder zusätzlich kann ein Karosserieklebeband vorgesehen sein, z. B. entlang der Innenseite des Verkleidungsteils. Die Verklebung kann nach Art einer Verfugung erfolgen. Alternativ oder zusätzlich können verbleibende Spalte mit Silikon ausgefüllt sein.

Das Rahmenbauteil kann mit einer Folie bedeckt sein, insbesondere einer in Einbaulage außenseitigen Folie. Diese Folie kann zur Farbgebung des Kraftfahrzeugs aus einem farbigen und/oder bunten Kunststoff gebildet sein. In einem Bereich einer Klebestelle des Verkleidungsteils kann dabei die Folie für eine besonders sichere Verbindung entfernt sein. Falls das Rahmenbauteil eine flächige Überdeckung mit dem Verkleidungsteil aufweist, beispielsweise indem der Aufnahmebereich eine zumindest abschnittsweise oder vollständig durchgängige Rückwand und/oder Verstrebungen aufweist (etwa wenn der Aufnahmebereich in Form einer Wanne zum Halten des Verkleidungsteils ausgebildet ist), kann die Rückwand und/oder können die Verstrebungen lackiert sein und/oder mit einer farbigen Folie versehen sein (z. B. beklebt). So kann ein entsprechend eingefärbtes Rahmenbauteil für einen Betrachter von außerhalb des Kraftfahrzeugs dieses bei einem ansonsten im Wesentlichen farblos und durchsichtig gestalteten Verkleidungsteil auch im Bereich des Verkleidungsteils farblich gestalten. Dafür ist insbesondere eine farbige Folie an dem Rahmenbauteil auf der dem Verkleidungsteil zugewandten Seite geeignet, welche vorzugsweise im Bereich jeweiliger Klebestellen freigeschnitten ist.

Das Karosserieteil kann mindestens eine Anschlussdose (eine sogenannte "junction box") aufweisen. Die Anschlussdose weist vorzugsweise mindestens eine Blockingdiode und/oder mindestens eine Bypass diode auf. Die Anschlussdose ist vorzugsweise auf der im eingebauten Zustand innenliegenden Seite des Verkleidungsteils, des Rahmenbauteils und/oder des Karosserieteils angebracht.

Ein weiterer Aspekt der Erfindung betrifft ein Kraftfahrzeug mit einem Karosserieteil gemäß dem ersten Aspekt der Erfindung. Die sich aus dem Karosserieteil gemäß dem ersten Erfindungsaspekt ergebenden Merkmale und Vorteile sind der Beschreibung des ersten Erfindungsaspekts zu entnehmen, wobei vorteilhafte Ausgestaltungen des ersten Erfindungsaspekts als vorteilhafte Ausgestaltungen des Kraftfahrzeugs und umgekehrt anzusehen sind.

Ein weiterer Aspekt der Erfindung betrifft ein Verfahren zum Herstellen eines Karosserieteils eines Kraftfahrzeugs. Mit diesem Verfahren wird ein Karosserieteil gemäß dem ersten Aspekt der Erfindung hergestellt werden. Die sich aus dem ersten Erfindungsaspekt ergebenden Merkmale und Vorteile sind Beschreibungen des ersten Erfindungsaspekts zu entnehmen, wobei vorteilhafte Ausgestaltungen des ersten Erfindungsaspekts als vorteilhafte Ausgestaltungen des zweiten Erfindungsaspekts und umgekehrt anzusehen sind.

Das erfindungsgemäße Verfahren umfasst die folgenden Schritte:
- Bereitstellen eines Verkleidungsteilrohlings;
- Verformen des Verkleidungsteilrohlings;
- Erzeugen wenigstens einer im Wesentlichen luftdicht und im Wesentlichen wasserdicht verschließbaren Aussparung, in welcher mehrere steife, plane Solarzellen, welche elektrisch miteinander verbunden sind, angeordnet sind, mittels welcher von dem fertigen Karosserieteil elektrische Energie erzeugbar ist;
- Verschließen der wenigstens einen Aussparung des Verkleidungsteilrohlings mit der wenigstens einen darin oder daran angeordneten Solarzelle zum Bilden eines fertigen Verkleidungsteils;
- Bereitstellen eines Rahmenbauteils mit einem Aufnahmebereich für das Verkleidungsteil;
- Anordnen des Verkleidungsteils in dem Aufnahmebereich des Rahmenbauteils.

Eine Außenseite des Verkleidungsteils weist hierbei vorzugsweise in wenigstens einem Bereich benachbart zu der wenigstens einen Solarzelle eine dreidimensional gekrümmte Außenform auf, welche so ausgebildet ist, dass sie in Einbaulage an dem Kraftfahrzeug einen Teil einer Fahrzeugaußenkontur bildet, insbesondere einen Teil einer dreidimensional gekrümmten Fahrzeugaußenkontur. Zu diesem Zweck wird der Verkleidungsteilrohling vorzugsweise verformt. Das Verformen kann unter Erwärmung des Verkleidungsteilrohlings erfolgen. Der Verkleidungsteilrohling kann wenigstens eine Polycarbonatscheibe umfassen. Diese Polycarbonatscheibe kann vorzugsweise in einem Tauchbad mit einem schützenden Hardcoating versehen werden, welches farblos und transparent ist und für eine anschließende Verformung geeignet ist.

Vorzugsweise weist der Aufnahmebereich eine Stufe auf. Vorteilhafterweise ist das Verkleidungsteil derart im Aufnahmebereich angeordnet, dass es an der Stufe gehalten ist und/oder die Außenseite des Verkleidungsteils im Wesentlichen bündig an einer Außenseite des Rahmenbauteils anschließt.

Das Verschließen der jeweiligen Aussparung kann vorzugsweise durch Autoklavieren erfolgen, beispielsweise indem der Verkleidungsteilrohling in einem Vakuumsack bei 120° für 3 Stunden erwärmt wird. Dabei kann innerhalb der Aussparung ein Unterdruck und/oder außerhalb davon ein Überdruck angelegt werden. Durch das Autoklavieren können jeweilige Aussparungen besonders frei von jeweiligen Verunreinigungen wie Schmutz, Luft und/oder Wasser sein, wodurch die Lebensdauer der Solarzellen und/oder deren Wirkungsgrad besonders hoch sein kann.

Alternativ zum Autoklavieren kann auch ein Prozess genutzt werden, der im Bereich der Herstellung von Solarzellen und Solarmodulen als Laminierungsprozess oder Laminierung bezeichnet wird. Dafür kann beispielsweise ein sogenannter Laminator genutzt werden, in dem ein Vakuum erzeugt werden kann. Dabei wird insbesondere im Vergleich zum Autoklavieren noch ein externer Druck aufgebracht, beispielsweise durch ein Formwerkzeug. Beispielsweise können jeweilige Rohlinge auf einen geheizten Werkzeugtisch aufgelegt werden und dort mit einem Werkzeug in Form gepresst werden. Auch dabei können jeweilige Lagen evakuiert werden, z. B. indem sie in dem Laminator angeordnet sind, und bei einem technischen Vakuum verpresst werden. Pressdauer und Temperatur können dabei von der Dicke und dem zu erreichenden Verformungsgrad abhängen. Beispielsweise wird aufgrund des atmosphärischen Drucks üblicherweise mit ca. 1 Atmosphäre Druck gepresst. Es kann aber auch zusätzlicher Druck zum Pressen aufgebracht werden, beispielweise zusätzliche 1 bis 3 Atmosphären Druck. Gepresst wird dabei beispielsweise für 2 Minuten bei 200° C. Üblicherweise wird dabei erst vakuumiert und dann gepresst. Im Rahmen dieser Anmeldung soll "Laminieren", "Laminierung" und "Laminierungsprozess" im Sinne des Sprachgebrauchs im Bereich der Herstellung von Solarzellen und Solarmodulen verstanden werden.

Verschiedene Verfahren zum Laminieren und/oder Autoklavieren können zur endgültigen Formgebung des Karosseriebauteils mit dreidimensional gekrümmter Außenform eingesetzt werden. Beispielsweise kann zunächst eine im Wesentliche flache Struktur mit bereits enthaltenen Solarzellen durch Laminieren erzeugt werden und anschließend durch ein Werkzeug in Form gepresst werden, ggf. unter vorheriger Erwärmung. Alternativ können jeweilige Lagen direkt auf einem Formwerkzeug angeordnet werden und gleichzeitig mit dem Laminieren in die Endform gepresst werden. Hierbei kann direkt auf einem Formwerkzeug laminiert werden. Optional kann dabei eine strukturell stützende aber formbare Rücklage, wie ein Aluminiumblech, vorgesehen werden. Dadurch ist die Ausschussrate des Prozesses besonders klein. Ohne stützende Rücklage kann das hergestellte Karosseriebauteil besonders leicht sein. Hier kann beispielsweise das Träger- und/oder Rahmenbauteil die stützende Rücklage bilden. Eine weitere Möglichkeit ist, zunächst wenigstens eine Schicht auf einem Werkzeug in Form zu pressen, dann wenigstens eine weitere Schicht darüber anzuordnen und diese, unter gleichzeitigem Laminieren, ebenfalls in Form zu pressen. Dadurch können insbesondere sehr dicke und/oder schwer zu formende Schichten verwendet werden. Als Formungsverfahren kann beispielsweise auch Tiefziehen verwendet werden.

Das erfindungsgemäße Verfahren umfasst vorzugsweise einen Schritt des Anordnens einer Vielzahl von Solarzellen an dem Verkleidungsteilrohling, insbesondere einen Schritt des Anordnens einer Vielzahl planer Solarzellen an dem Verkleidungsteilrohling. Die Solarzellen werden vorzugsweise an dem Verkleidungsteilrohling angebracht, nachdem dieser verformt wurde.

Das Anordnen einer Vielzahl von Solarzellen an dem Verkleidungsteilrohling kann mittels einer Schablone erfolgen. Mittels der Schablone kann eine besonders präzise Ausrichtung der Solarzellen in dem Verkleidungsteil erreicht werden. Sofern der Verkleidungsteilrohling nach dem Anbringen der Solarzellen verformt werden soll, können die Solarzellen mittels der Schablone auch so ausgerichtet werden, dass diese vor dem Verformen des Verkleidungsteilrohlings so an dem Verkleidungsteilrohling angeordnet sind, dass diese nach dem Verformen in jeweiligen Aussparungen angeordnet sind und es dabei nicht zu einer Beschädigung jeweiliger Solarzellen kommt. Die Schablone kann beispielsweise eine Folie sein, auf welcher jeweilige Stellen eingezeichnet sind, an welchen jeweilige Solarzellen angeordnet werden müssen. Diese Folie kann rückseitig unter den Verkleidungsteilrohling gelegt werden, falls dieser an korrespondierenden Stellen transparent ausgebildet ist und kann nach Platzieren, Befestigen und/oder Verschließen jeweiliger Aussparungen entfernt und gegebenenfalls wiederverwendet werden. Die Schablone kann aber auch in einer Folie zum Verschließen der Aussparung integriert sein, wodurch der Montageaufwand besonders gering sein kann. Entsprechend sind die bereits oben genannten FolienMaterialien geeignet.

Das erfindungsgemäße Verfahren kann ferner einen Schritt des elektrischen Verbindens der Vielzahl von Solarzellen, insbesondere mittels Lötens, aufweisen. Das elektrische Verbinden erfolgt entweder vor dem Anordnen der Solarzellen an dem Verkleidungsteilrohling oder danach. Bei dem Verbinden davor können beispielsweise jeweilige teilvormontierte Bauteile wie Strings von Solarzellen genutzt werden, wodurch die Fertigung besonders kostengünstig sein kann. Bei dem elektrischen Verbinden der jeweiligen Solarzellen erst nach dem Platzieren an oder in der Aussparung können jeweilige Lagetoleranzen bei diesem Platzieren besonders hoch sein.

Gemäß des erfindungsgemäßen Verfahrens kann ein Freiraum zwischen der wenigstens einen Solarzelle und jeweiligen, die zugeordnete Aussparung begrenzenden Wandungen des Verkleidungsteils mit einem Silikongel gefüllt werden, wobei vorzugsweise eine Einfüllöffnung für das Silikongel beim Einfüllen an einem durch die Schwerkraft definierten unteren Ende liegt und eine Entlüftungsöffnung an einem durch die Schwerkraft definierten oberen Ende liegt. Das Silikongel wird also entgegen der Schwerkraft von unten nach oben in jeweilige Aussparungen eingefüllt. Dadurch kann ein Bilden von Luftblasen besonders gut unterdrückt werden. Vorzugsweise wird dabei ein hochtransparenter Silikonkautschuk in den Freiraum eingefüllt, welches dort zu einem transparenten Silikongel vulkanisiert. Die Vulkanisierung kann bei Zimmertemperatur aber auch unter Erwärmung erfolgen, beispielsweise beim Autoklavieren.

Vorzugsweise wird wenigstens eine Kunststofffolie an der Aussparung zu deren Verschließen angeordnet, insbesondere eine thermoplastische Folie (wie etwa eine TPU-Folie), wobei die Aussparung mit der daran angeordneten Kunststofffolie insbesondere bei Unterdruck, Überdruck und/oder unter Erwärmung versiegelt wird. Auch die oben bereits genannten Materialien für Folien, wie PTFE und ETFE, sind geeignet. Der Unterdruck wird dabei vorzugsweise in einem durch die Folien zu verschließenden Hohlraum eingebracht und/oder der Überdruck von außen an dem zu verschließenden Hohlraum angelegt. Aufgrund der wenigstens einen Kunststofffolie können jeweilige Fertigungstoleranzen von strukturell festen Bauteilen, welche die Aussparung bilden, relativ hoch sein. Beispielsweise kann ein Trägerelement, welches die Aussparung aufweist, mit einer hohen Fertigungstoleranz gefertigt sein, während flexible Kunststofffolien dennoch die Aussparung gut versiegeln können und dabei Fertigungstoleranzen kompensieren können. Das Versiegeln bei Unterdruck, Überdruck und/oder unter Erwärmung kann auch als Autoklavieren bezeichnet werden, wobei insbesondere außerhalb des durch die Folien gebildeten Hohlraums auch ein Überdruck angelegt werden kann. Jeweilige TPU-Folien sind besonders geeignet für ein innenseitiges Versiegeln, beispielsweise als zwei TPU-Folienschichten zwischen zwei Polycarbonatscheiben, da diese bei Erwärmung besonders gut miteinander verschmelzen können und dabei gleichzeitig die Polycarbonatscheiben sicher aneinander befestigen.

Vorzugsweise weist der Verkleidungsteilrohling zwei Scheiben auf, zwischen welchen die wenigstens eine Solarzelle angeordnet wird. Die Scheiben werden im Rahmen des erfindungsgemäßen Verfahrens vorzugsweise verformt, um die dreidimensional gekrümmte Außenseite und/oder eine dreidimensional gekrümmte Innenseite des Verkleidungsteils zu erzeugen. Vorzugsweise werden die zwei Scheiben dabei vor der Anordnung der Solarzelle verformt, beispielsweise mittels eines Formwerkzeugs. Die zwei Scheiben können dabei vor und/oder nach der Verformung beispielsweise mittels eines doppelseitigen Klebebands, vorzugsweise eines doppelseitigen Acrylklebebands, in ihrer jeweiligen relativen Position zueinander festgelegt werden. Dieses Klebeband kann dabei auch als Abstandshalter zwischen den zwei Scheiben dienen und als seitliche Abdichtung jeweiliger Aussparungen.

Das Formwerkzeug zum Verformen des Verkleidungsteilrohlings kann auch als Haltevorrichtung für das Autoklavieren und/oder Laminieren beim Verschließen der jeweiligen Aussparung dienen. Dadurch müssen jeweilige Elemente des Verkleidungsteils nicht mehr umgespannt werden, wodurch die Fertigung besonders kostengünstig und präzise sein kann.

Vorzugsweise weist das Verfahren die folgenden weiteren Schritte auf:
- Anordnen einer ersten Kunststofffolie auf einer der Aussparung zugewandten Seite einer ersten der zwei Scheiben;
- Anordnen der wenigstens einen Solarzelle auf der ersten Kunststofffolie;
- Anordnen einer zweiten Kunststofffolie auf der wenigstens einen Solarzelle und der ersten Kunststofffolie;
- Anordnen der zweiten Scheibe auf der zweiten Kunststofffolie oder Anordnen der zweiten Kunststofffolie auf der zweiten Scheibe;
- Verbinden der ersten mit der zweiten Kunststofffolie wenigstens in einem Teilbereich miteinander zum Verschließen der wenigstens einen Aussparung, insbesondere durch Autoklavieren und/oder Laminieren.

Hierbei kann die zweite Kunststofffolie auf der zweiten Scheibe angeordnet werden, bevor die an der zweiten Scheibe angeordnete Kunststofffolie dann mit der zweiten Scheibe auf der ersten Scheibe und/oder auf der ersten Kunststofffolie platziert wird. So kann die Aussparung besonders einfach im Wesentlichen luftdicht und/oder im Wesentlichen wasserdicht verschlossen werden. Die zweite Kunststofffolie kann jedoch auch einfach mittig auf der ersten Kunststofffolie und jeweiligen Solarzellen platziert und/oder fallen gelassen werden. Die zwei Scheiben können dabei durch die zwei Folien miteinander verbunden werden. Vorzugsweise handelt es sich bei den jeweiligen Kunststofffolien um thermoplastische Polyurethanfolien. Es kann ein jeweiliges Formwerkzeug als Haltevorrichtung beim Autoklavieren und/oder Laminieren dienen. Weitere Vorteile, Merkmale und Einzelheiten der Erfindung ergeben sich aus der nachfolgenden Beschreibung eines bevorzugten Ausführungsbeispiels sowie anhand der Zeichnungen. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Die Erfindung ist alleinig in den Patentansprüchen definiert.
Fig. 1 zeigt in einer Seitenansicht ein Kraftfahrzeug mit mehreren Karosserieteilen;
Fig. 2 zeigt das Kraftfahrzeug gemäß Fig. 1 in einer Draufsicht;
Fig. 3 zeigt in einer seitlichen Draufsicht ein Karosserieteil des Kraftfahrzeugs gemäß Fig. 1;
Fig. 4 zeigt in einer Schnittansicht das Karosserieteil gemäß Fig. 3;

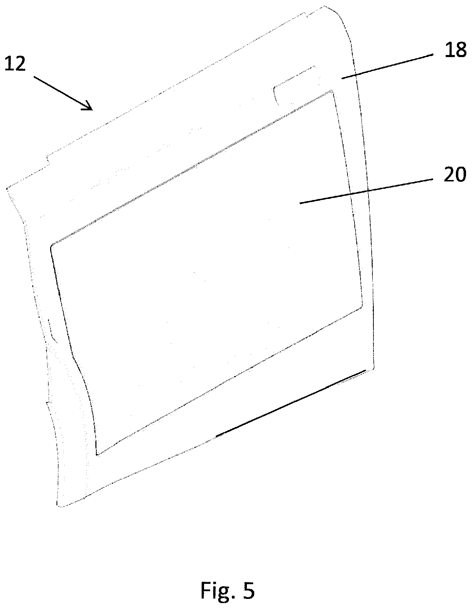

Fig. 5 zeigt in einer Perspektivansicht das Karosserieteil gemäß Fig. 3;
Fig. 6 veranschaulicht schematisch einen Teil eines Herstellungsverfahrens des Karosserieteils gemäß Fig. 3;
Fig. 7 veranschaulicht in einer schematischen Schnittansicht einen Aufbau des Karosserieteils gemäß Fig. 3;
Fig. 8 zeigt schematisch die Verbindung zwischen einem Rahmenbauteil und einem daran angeordneten Verkleidungsteil des Karosserieteils gemäß Fig. 3;
Fig. 9 veranschaulicht in einer schematischen Schnittansicht einen weiteren Teil eines Herstellungsverfahrens des Karosserieteils gemäß Fig. 3.

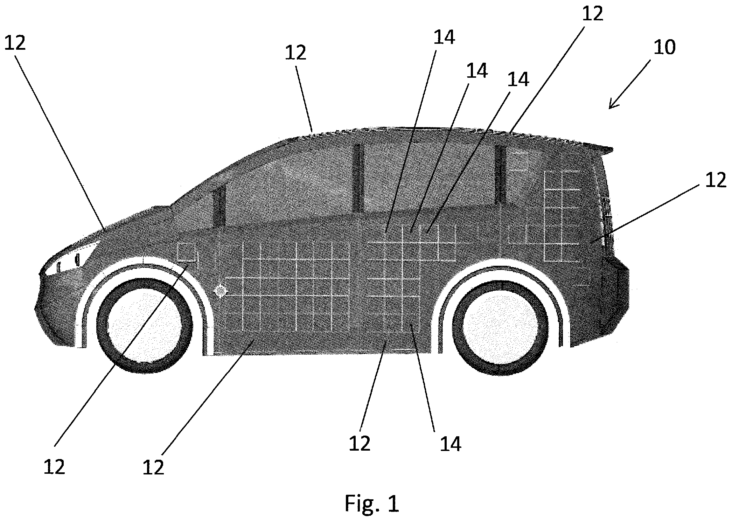

Fig. 1 zeigt ein Kraftfahrzeug 10 in einer Seitenansicht, welches mehrere Karosserieteile 12 aufweist. Erfindungsgemäße Karosserieteile können beispielsweise eine oder mehrere Türen, eine Motorhaube, ein Dach, eine Heckklappe, eine Stoßstange (vorne und/oder hinten) und/oder einer oder mehrere Kotflügel (vorne und/oder hinten) sein. Es können einzelne, beliebige Unterkombinationen oder auch alle dieser Karosserieteile als erfindungsgemäße Karosserieteile ausgestaltet sein. In diesen Karosserieteilen 12 ist jeweils eine Mehrzahl von Solarzellen 14 angeordnet, welche von außen einstrahlendes Sonnenlicht in elektrische Energie umwandeln können. Zu diesem Zweck ist eine jeweilige Außenseite der Karosserieteile 12 wenigstens bereichsweise transparent ausgebildet, so dass jeweilige Sonnenstrahlen die Solarzellen 14 erreichen und zur Energieerzeugung anregen können.

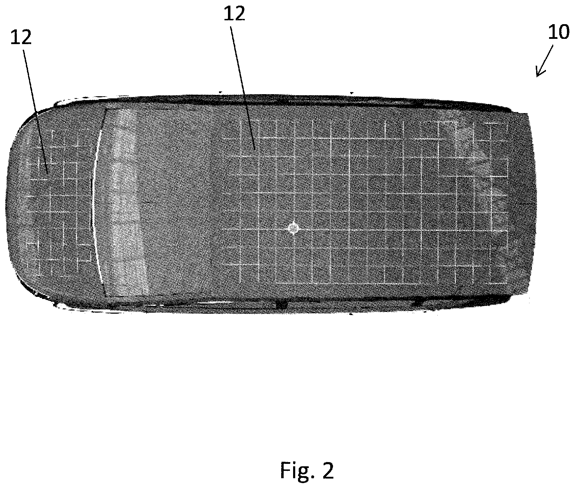

Fig. 2 zeigt in einer Draufsicht das Kraftfahrzeug 10 gemäß Fig. 1, wobei auch jeweilige Karosserieteile 12 auf dem Dach und der Motorhaube des Kraftfahrzeugs 10 zu erkennen sind.

Weiterhin ist in den Fig. 1 und 2 zu erkennen, dass jeweilige Karosserieteile 12 wenigstens bereichsweise eine dreidimensional gekrümmte Außenform aufweisen. Dadurch bilden die Karosserieteile 12 auch in Einbaulage an dem Kraftfahrzeug 10 eine gekrümmte Außenkontur des Kraftfahrzeugs. Entsprechend kann das Kraftfahrzeug 10 aerodynamisch vorteilhaft gestaltet werden und ein elegantes Erscheinungsbild aufweisen.

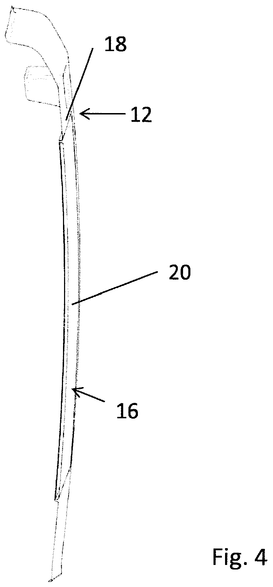

Die Solarzellen 14 sind dabei vorzugsweise steife und plane Solarzellen, vorzugsweise mit jeweils identischen Abmessungen und Eigenschaften, insbesondere einer jeweils identischen Bestrahlungsfläche. Die Solarzellen 14 selbst sind dabei nicht an die gekrümmte Außenkontur des Kraftfahrzeugs 10 bzw. des Verkleidungsteils 20 angepasst, da entsprechend geformte Solarzellen sehr aufwendig und teuer herzustellen sind. Stattdessen werden bei allen Karosserieteilen 12 im Wesentlichen identische plane Solarzellen 14 eingesetzt. Um dennoch mit den Karosserieteilen 12 eine dreidimensional gekrümmte Außenkontur bilden zu können, sind die Solarzellen 14 in jeweiligen Aussparungen 16 angeordnet, welche beispielsweise in den Fig. 4, 6, 7 und 9 zu erkennen sind. Mittels dieser Aussparungen 16 können jeweilige Teile des Karosserieteils 12 eine im Wesentlichen konstante Dicke und dreidimensional gekrümmte Außenform aufweisen, wobei dennoch genügend Bauraum für das Anordnen der planen Solarzellen 14 vorhanden ist. Dies bedeutet, dass die planen Solarzellen 14 beispielsweise näher an einem Ende an einer außenseitigen Wandung der Aussparung 16 angeordnet sein können als an einem anderen Ende, da diese über eine breite der Aussparung 16 nicht der Krümmung der Außenkontur folgen. Die Solarzellen 14 müssen dabei auch nicht parallel zu jeweiligen Wandungen der Aussparung 16 angeordnet sein, wodurch diese zudem besonders in gut in einer Neigung an einen voraussichtlichen Einstrahlwinkel des Sonnenlichts angepasst werden können.

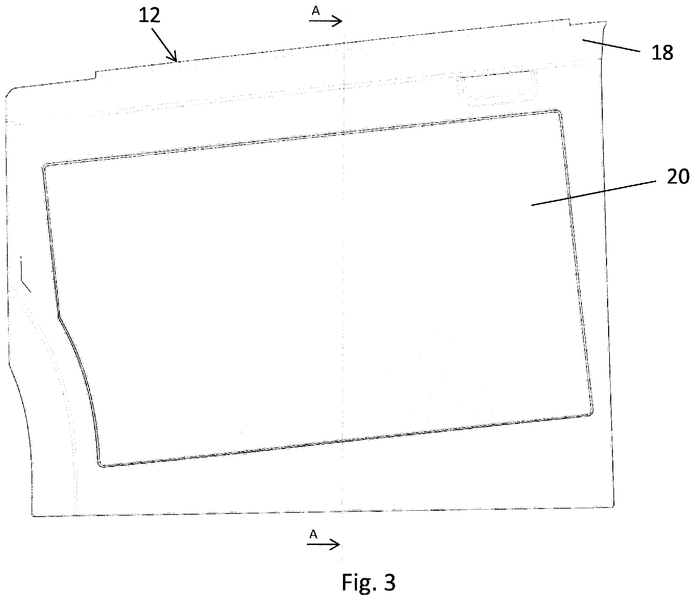

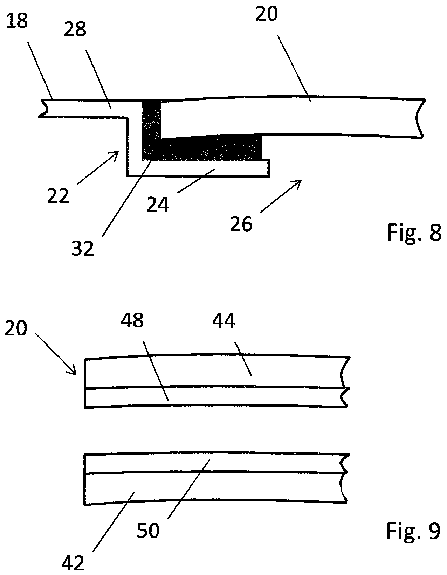

In der Seitenansicht gemäß Fig. 3 ist beispielhaft ein Karosserieteil 12 des Kraftfahrzeugs 10 gemäß Fig. 1 gezeigt, wobei es sich hierbei um die linke Vordertür des Kraftfahrzeugs 10 handelt. Dabei ist zu erkennen, dass das Karosserieteil 12 ein Rahmenbauteil 18 und ein daran angeordnetes Verkleidungsteil 20 aufweist. Das Rahmenbauteil 18 kann dabei eine strukturell tragende Funktion übernehmen und das Verkleidungsteil 20 an dem restlichen Kraftfahrzeug 10 halten. Vorzugsweise ist das Rahmenbauteil 18 dabei als CFK-Bauteil ausgebildet, welches besonders leicht und steif ist. Das Rahmenbauteil 18 schließt dabei das Verkleidungsteil 20 nach Art eines Rahmens außen umlaufend ein. Dadurch kann das Verkleidungsteil 20 das Rahmenbauteil 18 wenigstens in dessen Haupterstreckungsebene abstützen und zusätzlich versteifen. Insgesamt kann das Karosserieteil 12 so besonders leicht sein. Vorzugsweise ist das Verkleidungsteil 20 dabei an dem Rahmenbauteil 18 an einer Stufe 22 gehalten, wie dies beispielsweise schematisch in der Schnittansicht gemäß Fig. 8 gezeigt ist. Das Rahmenbauteil 18 weist hier eine Z-förmige Stufe 22 auf, an deren unterem Schenkel 24 das Verkleidungsteil 20 aufliegt. Der untere Schenkel 24 erstreckt sich dabei nur bereichsweise unter dem Verkleidungsteil 20, ansonsten kann mittig in einem Aufnahmebereich für das Verkleidungsteil 20 zur Gewichtsreduktion eine Durchgangsöffnung 26 in dem Rahmenbauteil 18 vorgesehen sein. Der obere Schenkel 28 der Z-förmigen Stufe 22 schließt dabei bündig in einer Ebene an dem Verkleidungsteil 20 an. Dies ist aerodynamisch besonders vorteilhaft.

In einem Spalt 30 zwischen dem Verkleidungsteil 20 und dem Rahmenbauteil 18 kann ein Kleber 32 angeordnet sein, beispielsweise ein Acrylkleber. Dieser Kleber 32 kann nicht nur zur Fixierung des Verkleidungsteils 20 an dem Rahmenbauteil 18 dienen, sondern kann auch eine Kompensation unterschiedlicher thermischer Ausdehnungskoeffizienten ermöglichen. Beispielsweise kann das Rahmenbauteil 18 aus einem kohlefaserverstärkten Kunststoff gebildet sein und das Verkleidungsteil 20 im Wesentlichen aus Polycarbonatscheiben. In diesem Fall müssen unterschiedliche thermische Ausdehnungskoeffizienten kompensiert werden. Dies ist durch den Spalt 30 und den Kleber 32 besonders gut möglich. Alternativ oder zusätzlich kann ein doppelseitiges Klebeband (etwa ein doppelseitiges Karosserieklebeband zwischen dem unteren Schenkel 24 und dem Verkleidungsteil 20) vorgesehen sein.

Rückseitig an einer dem Innenraum des Kraftfahrzeugs 10 zugewandten Seite kann das Verkleidungsteil 20 lackiert sein, insbesondere farbig, um so das Kraftfahrzeug 10 nach außen für jeweilige Beobachter farbig zu gestalten. Außenseitig auf einer dem Lichteinfall zugewandten Seite kann das Verkleidungsteil 20 dagegen beispielsweise mit einem Klarlack versehen sein, um jeweilige Bauteile zu schützen und dennoch den Lichteinfall in die Solarzellen 14 nicht zu behindern. Eine entsprechende Farbe oder ein entsprechender Klarlack kann auch auf dem Rahmenbauteil 18 für ein einheitliches Erscheinungsbild aufgebracht sein.

Vorzugsweise ist die Aussparung 16 des Verkleidungsteils 20 im Wesentlichen luftdicht und im Wesentlichen wasserdicht verschlossen. Dadurch können jeweilige Solarzellen 14 vor äußeren Umwelteinflüssen geschützt werden.

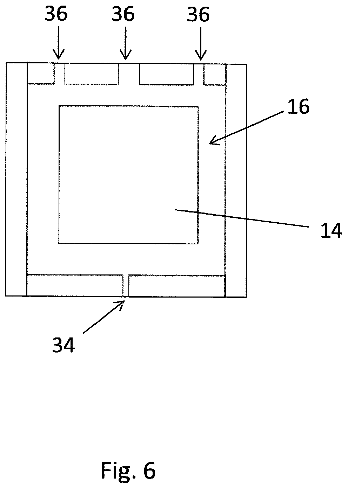

Zu diesem Zweck kann es beispielsweise vorgesehen sein, einen Freiraum in der Aussparung 16 zwischen der Solarzelle 14 und jeweiligen Wandungen der Aussparung 16 mit einem Silikongel zu füllen. Dafür kann in die Aussparung 16 nach Anordnen der Solarzellen 14 ein Silikonkautschuk eingefüllt werden, welcher dort anschließend vulkanisiert. Vorzugsweise wird dabei - wie in Fig. 6 gezeigt - der Silikonkautschuk in eine oder mehrere untere Einfüllöffnungen 34 entgegen der Schwerkraft in die Aussparung 16 eingebracht. Durch das Einbringen entgegen der Schwerkraft kann eine Bildung von Luftblasen besonders zuverlässig verhindert werden. Dabei sollte bevorzugt an einem oberen Ende wenigstens eine Entlüftungsöffnung 36 vorgesehen sein, durch welche jeweilige in der Aussparung 16 befindliche Luft beim Befüllen austreten kann. Diese jeweiligen Einfüllöffnungen 34 und Entlüftungsöffnungen 36 können nach dem Befüllen zusätzlich verschlossen werden oder aber auch durch das vulkanisierte Silikongel selber abgedichtet werden.

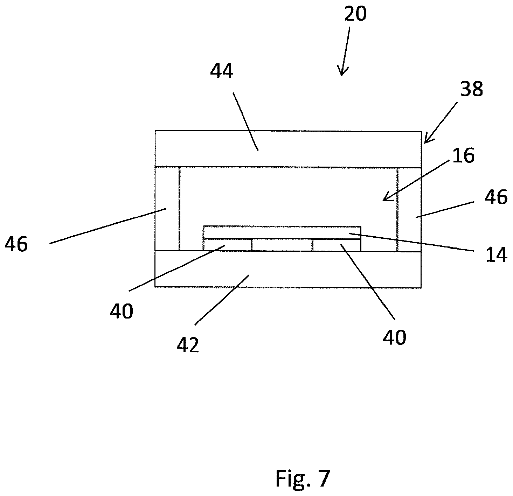

Wie in Fig. 7 gezeigt, kann das Verkleidungsteil 20 dabei beispielsweise zwei Scheiben aufweisen, welche zusammen ein Trägerelement 38 bilden. Die Solarzelle 14 ist dabei beispielsweise mittels seines doppelseitigen Acrylklebebands 40 an einer innenseitigen ersten Polycarbonatscheibe 42 angebracht. Darüber hinaus ist in Richtung der Außenseite des Karosserieteils 12 eine zweite Polycarbonatscheibe 44 angeordnet, welche an der ersten Polycarbonatscheibe 42 mit jeweiligen doppelseitigen Acrylklebebändern 46 befestigt ist. Die Acrylklebebänder 46 dienen dabei nicht nur als Abstandshalter, sondern können auch die Aussparung 16 wenigstens teilweise abdichten, insbesondere seitlich. Die Polycarbonatscheiben 42, 44 können dabei beispielsweise eine Dicke von 1 mm bis 4 mm aufweisen, vorzugsweise 2 mm bis 3 mm oder 2,5 mm, und die Aussparung 16 kann in der Querschnittsansicht gemäß Fig. 7 eine Höhe von beispielsweise 1 mm bis 4 mm aufweisen, vorzugsweise 1 mm bis 3 mm, z. B. ungefähr 2 mm.

Ergänzend oder alternativ kann das Verkleidungsteil 20 auch einen Schichtaufbau aufweisen, welcher in Fig. 9 veranschaulicht ist. Hier ist jeweils innenseitig zu auf der der Aussparung 16 zugewandten Seite der ersten Polycarbonatscheibe 42 und der zweiten Polycarbonatscheibe 44 eine thermoplastische Polyurethanfolie 50 bzw. 48 angeordnet. Mittels dieser TPU-Folien 50, 48 können jeweilige Aussparungen 16 mit darin befindlichen Solarzellen 14 wasserdicht und luftdicht gekapselt werden. Dazu wird das Verkleidungsteil 20 beispielsweise in einen Vakuumsack eingebracht und für 3 Stunden bei 120° autoklaviert. In jeweiligen Teilbereichen, in welchen keine Aussparung 16 angeordnet ist und die erste und die zweite TPU-Folie 50, 48 miteinander kontaktiert sind, verschmelzen diese dabei miteinander und verschließen so die Aussparung 16. Dabei werden gleichzeitig die beiden Polycarbonatscheiben 42, 44 mittels der TPU-Folien 50, 48 miteinander verbunden.

In einem beispielhaften Herstellungsverfahren werden die Polycarbonatscheiben 42, 44 als plane Scheiben zur Verfügung gestellt. Diese beiden planen Scheiben werden mittels eines Formwerkzeugs und optional mittels zusätzlicher Erwärmung in die dreidimensional gekrümmte Form gemäß der Außenkontur des Kraftfahrzeugs 10 verformt. Bei dieser Verformung werden gleichzeitig jeweilige Wölbungen in die Polycarbonatscheiben 42, 44 eingebracht. Anschließend wird beispielsweise eine der beiden TPU-Folien 50, 48 auf die zugeordnete Polycarbonatscheibe 42, 44 aufgelegt und mithilfe einer Schablone die jeweiligen Solarzellen 14 darauf angeordnet. Entsprechend einer vorgegebenen Schaltung werden dann die Solarzellen 14 elektrisch miteinander verbunden und wenigstens ein elektrischer Ausgang an dem Verkleidungsteil 20 vorgesehen, mittels welchem elektrischer Strom zu jeweiligen Energiespeichern des Kraftfahrzeugs 10 geleitet werden kann. Anschließend wird die andere der beiden TPU-Folien 50, 48 aufgelegt und dann die andere der beiden Polycarbonatscheiben 42, 44. Vorzugsweise ist dabei dieser Schichtaufbau weiterhin an wenigstens einem der Formwerkzeuge des Formprozesses der Polycarbonatscheiben 42, 44 gehalten. Anschließend kann die gesamte Schichtkonstruktion in einem Vakuumsack eingeführt und für beispielsweise 3 Stunden bei 120° autoklaviert werden. Die Solarzellen 14 sind dann luft- und wasserdicht in den Aussparungen 16 geschützt vor Umwelteinflüssen versiegelt und die jeweiligen Polycarbonatscheiben 42, 44 fest miteinander verbunden. Anschließend kann das so erzeugte Verkleidungsteil 20 an der Z-Stufe 22 des Rahmenbauteils 18 eingeklebt werden. Aufgrund der Versiegelung der Solarzellen 14 ist die Montage dabei besonders einfach, da die Solarzellen 14 nun bereits vor Beschädigungen und Verunreinigungen geschützt sind und ohne besondere Vorsichtsmaßnahmen als Art Modul in das Rahmenbauteil 18 eingesetzt werden können.

Die Solarzellen 14 können dabei beispielsweise bereits als miteinander elektrisch verbundene Solarzellen-Strings zur Verfügung gestellt werden. Ein String kann dabei einer Reihe der Solarzellen 14 in einem Verkleidungsteil 20 entsprechen. Ein solcher String kann dann in einer jeweiligen gemeinsamen Aussparung 16 des Verkleidungsteils 20 gemeinsam eingelegt werden, so dass direkt mehrere Solarzellen 14 in einer korrekten Anordnung in dem Verkleidungsteil 20 angeordnet sind. Danach können mehrere Strings miteinander elektrisch verbunden werden.

### Bezugszeichenliste

- 10: Kraftfahrzeug
- 12: Karosserieteil
- 14: Solarzelle
- 16: Aussparung
- 18: Rahmenbauteil
- 20: Verkleidungsteil
- 22: Stufe
- 24: unterer Schenkel
- 26: Durchgangsöffnung
- 28: oberer Schenkel
- 30: Spalt
- 32: Kleber
- 34: Einfüllöffnungen
- 36: Entlüftungsöffnung
- 38: Trägerelement
- 40: Klebeband
- 42: Polycarbonatscheibe
- 44: Polycarbonatscheibe
- 46: Klebeband
- 48: TPU-Folie
- 50: TPU-Folie

## Patentansprüche

1. Karosserieteil (12) eines Kraftfahrzeugs (10) mit wenigstens einem Rahmenbauteil (18) und wenigstens einem daran angeordneten Verkleidungsteil (20),
wobei das Verkleidungsteil (20) wenigstens eine im Wesentlichen luftdicht und im Wesentlichen wasserdicht verschlossene Aussparung (16) mit mehreren darin angeordneten steifen, planen Solarzellen (14), welche elektrisch miteinander verbunden sind, zum Erzeugen einer elektrischen Energie aufweist,
und wobei die Außenseite des Verkleidungsteils (20) wenigstens in einem Bereich benachbart zu einer der Solarzellen (14) eine dreidimensional gekrümmte Außenform aufweist, welche so vorgesehen ist, dass sie in Einbaulage an dem Kraftfahrzeug (10) einen Teil einer Fahrzeugaußenkontur bildet,
**dadurch gekennzeichnet, dass**
das Rahmenbauteil ein wesentlich strukturell tragendes Bauteil des Karosserieteils ist, welches das Verkleidungsteil trägt und abstützt, insbesondere in Einbaulage am Kraftfahrzeug, wobei das Verkleidungsteil einen im Vergleich wesentlich kleineren strukturell tragenden Anteil hat.

2. Karosserieteil (12) nach Anspruch 1, wobei
die Außenseite des Verkleidungsteils (20) im Wesentlichen bündig an eine Außenseite des Rahmenbauteils (18) anschließt.

3. Karosserieteil (12) nach einem der vorhergehenden Ansprüche, wobei
das Verkleidungsteil (20) ein wenigstens bereichsweise gemäß der gekrümmten Außenkontur gekrümmtes Trägerelement (38) umfasst, in oder an welchem die wenigstens eine Solarzelle (14) angeordnet ist.

4. Karosserieteil (12) nach Anspruch 3, wobei
das Trägerelement (38) aus mindestens zwei Scheiben (42, 44) gebildet ist, wobei eine äußere der Scheiben (44) die Außenseite des Verkleidungsteils (20) bildet und eine innere der Scheiben (42) eine der Außenseite abgewandte Innenseite, wobei die Aussparung (16) zwischen den zwei Scheiben (42, 44) ausgebildet ist.

5. Karosserieteil (12) nach einem der Ansprüche 3 oder 4, wobei
ein Freiraum zwischen der wenigstens einen Solarzelle (14) und jeweiligen die zugeordnete Aussparung (16) begrenzenden Wandungen des Verkleidungsteils mit einem Silikongel gefüllt ist.

6. Karosserieteil (12) nach einem der Ansprüche 3 bis 5, wobei
die Aussparung (16) durch zwei an dem Trägerelement (38) angeordnete Folien (48, 50), insbesondere thermoplastische Polyurethanfolien begrenzt ist, welche zum Abdichten der Aussparung (16) miteinander verbunden sind.

7. Karosserieteil (12) nach einem der vorhergehenden Ansprüche, wobei
das Rahmenbauteil (18) einen Aufnahmebereich mit einer Stufe (22) aufweist, wobei das Verkleidungsteil (20) in dem Aufnahmebereich angeordnet ist.

8. Karosserieteil (12) nach Anspruch 7, wobei
die Stufe (22) des Rahmenbauteils (18) im Wesentlichen Z-förmig ausgebildet ist, wobei ein oberer Schenkel (28) der Z-förmigen Stufe (22) die Außenseite des Rahmenbauteils (18) bildet, welche sich im Wesentlichen bündig an das Verkleidungsteil (20) anschließt und wobei ein unterer Schenkel (24) der Stufe (22) eine Auflagefläche für das Verkleidungsteil (20) bildet.

9. Verfahren zum Herstellen eines Karosserieteils (12) gemäß einem der Ansprüche 1 bis 8, umfassend die Schritte:
- Bereitstellen eines Verkleidungsteilrohlings;
- Verformen des Verkleidungsteilrohlings;
- Erzeugen wenigstens einer im Wesentlichen luftdicht und im Wesentlichen wasserdicht verschließbaren Aussparung (16), in welcher mehrere steife, plane Solarzellen (14), welche elektrisch miteinander verbunden sind, angeordnet sind, mittels welchen von dem fertigen Karosserieteil (12) elektrische Energie erzeugbar ist;
- Verschließen der wenigstens einen Aussparung (16) des Verkleidungsteilrohlings mit den darin oder daran angeordneten Solarzellen (14) zum Bilden eines fertigen Verkleidungsteils (20);
- Bereitstellen eines Rahmenbauteils (18) mit einem Aufnahmebereich für das Verkleidungsteil (20);
- Anordnen des Verkleidungsteils (20) in dem Aufnahmebereich des Rahmenbauteils (18);
wobei eine Außenseite des Verkleidungsteils (20) wenigstens in einem Bereich benachbart zu einer der Solarzellen (14) eine dreidimensional gekrümmte Außenform aufweist, welche so ausgebildet ist, dass sie in Einbaulage an dem Kraftfahrzeug (10) einen Teil einer Fahrzeugaußenkontur bildet.

10. Verfahren nach Anspruch 9, ferner die Schritte aufweisend:
- Anordnen einer Vielzahl von im Wesentlichen planen Solarzellen (14) an dem Verkleidungsteilrohling mittels einer Schablone;
- Elektrisches Verbinden der Vielzahl von Solarzellen (14), insbesondere mittels Löten.

11. Verfahren nach einem der Ansprüche 9 oder 10, wobei
ein Freiraum zwischen der wenigstens einen Solarzelle (14) und jeweiligen die zugeordnete Aussparung (16) begrenzenden Wandungen des Verkleidungsteils (20) mit einem Silikongel gefüllt wird, wobei vorzugsweise eine Einfüllöffnung (34) für das Silikongel beim Einfüllen an einem durch die Schwerkraft definierten unteren Ende liegt und eine Entlüftungsöffnung (36) an einem durch die Schwerkraft definierten oberen Ende liegt.

12. Verfahren nach einem der Ansprüche 9 bis 11, ferner mit dem Schritt:
Anordnen wenigstens einer Kunststofffolie (48, 50) an dem Verkleidungsteilrohling zum Verschließen der Aussparung (16) umfasst, insbesondere einer TPU-Folie, wobei die Kunststofffolie (48, 50) zum Verschließen der Aussparung (16) insbesondere bei Unterdruck, Überdruck und/oder unter Erwärmung versiegelt wird.

13. Verfahren nach einem der Ansprüche 9 bis 12, wobei
der Verkleidungsteilrohling zwei Scheiben (42, 44) aufweist, zwischen welchen die wenigstens eine Solarzelle (14) angeordnet wird, wobei die Scheiben (42, 44) verformt werden.

14. Verfahren nach Anspruch 13, ferner die Schritte aufweisend:
- Anordnen einer ersten Kunststofffolie (50) auf einer ersten Seite einer ersten Scheibe (42) der zwei Scheiben;
- Anordnen der wenigstens einen Solarzelle (14) auf der ersten Kunststofffolie (50);
- Anordnen einer zweiten Kunststofffolie (48) auf der wenigstens einen Solarzelle (14) und/oder der ersten Kunststofffolie (50);
- Anordnen der zweiten Scheibe (44) auf der zweiten Kunststofffolie (48) und/oder Anordnen der zweiten Kunststofffolie (48) auf der zweiten Scheibe (44);
- Verbinden der ersten mit der zweiten Kunststofffolie (48, 50) wenigstens in einem Teilbereich miteinander zum Verschließen der wenigstens einen Aussparung (16), insbesondere durch Autoklavieren.

## Claims

1. Vehicle body part (12) of a motor vehicle (10) having at least one frame component (18) and at least one cladding part (20) that is arranged on said frame component,
wherein the cladding part (20) comprises at least one recess (16) that is closed in an essentially airtight and essentially watertight manner and that has multiple rigid planar solar cells (14) that are arranged therein and are electrically connected to one another in order to generate electrical energy,
and wherein the outer side of the cladding part (20) comprises at least in a region adjacent to one of the solar cells (14) a three-dimensional curved outer shape that is provided so that in an installed position on the motor vehicle (10) said outer shape forms a part of a vehicle outer contour,
**characterised in that**
the frame component is an essentially structurally supporting component of the vehicle body part and said frame component supports and braces the cladding part, in particular in the installed position on the motor vehicle, wherein the cladding part has an in comparison essentially smaller structurally supporting proportion.

2. Vehicle body part (12) according to claim 1, wherein
the outer side of the cladding part (20) essentially connects flush to an outer side of the frame component (18) .

3. Vehicle body part (12) according to one of the preceding claims, wherein the cladding part (20) comprises a supporting element (38) that is curved at least in regions in accordance with the curved outer contour and the at least one solar cell (14) is arranged in or on said supporting element.

4. Vehicle body part (12) according to claim 3, wherein
the supporting element (38) is formed from at least two sheets (42, 44), wherein an outer of the sheets (44) forms the outer side of the cladding part (20) and an inner of the sheets (42) forms an inner side that is remote from the outer side, wherein the recess (16) is embodied between the two sheets (42, 44).

5. Vehicle body part (12) according to one of claims 3 or 4,
wherein
a free space between the at least one solar cell (14) and respectively the walls of the cladding part that delimit the allocated recess (16) is filled with a silicone gel.

6. Vehicle body part (12) according to one of claims 3 to 5,
wherein
the recess (16) is delimited by means of two films (48, 50), in particular thermoplastic polyurethane films, that are arranged on the supporting element (38) and that are connected to one another so as to seal the recess (16).

7. Vehicle body part (12) according to one of the preceding claims, wherein the frame component (18) comprises a receiving region having a step (22), wherein the cladding part (20) is arranged in the receiving region.

8. Vehicle body part (12) according to claim 7, wherein
the step (22) of the frame component (18) is embodied in an essentially Z-shape, wherein an upper limb (28) of the Z-shaped step (22) forms the outer side of the frame component (18) and said outer side essentially connects flush to the cladding part (20) and wherein a lower limb (24) of the step (22) forms a resting surface for the cladding part (20).

9. Method for producing a vehicle body part (12) in accordance with one of claims 1 to 8, comprising the steps:
- providing a cladding part blank;
- deforming the cladding part blank;
- producing at least one essentially airtight and essentially watertight closable recess (16) in which multiple rigid planar solar cells (14) that are electrically connected to one another are arranged and it is possible by means of said solar cells to generate electrical energy from the finished vehicle body part (12;
- closing the at least one recess (16) of the cladding part blank having the solar cells (14) that are arranged therein or thereon so as to form a finished cladding part (20);
- providing a frame component (18) having a receiving region for the cladding part (20);
- arranging the cladding part (20) in the receiving region of the frame component (18);
wherein an outer side of the cladding part (20) comprises at least in a region adjacent to one of the solar cells (14) a three-dimensional curved outer shape that is provided so that in the installed position on the motor vehicle (10) said outer shape forms a part of a vehicle outer contour.

10. Method according to claim 9, moreover comprising the steps:
- arranging a plurality of essentially planar solar cells (14) on the cladding part blank by means of a template;
- electrically connecting the plurality of solar cells (14), in particular by means of soldering.

11. Method according to one of claims 9 or 10, wherein
a free space between the at least one solar cell (14) and respectively the walls of the cladding part (20) that delimit the allocated recess (16) is filled with a silicone gel, wherein it is preferred that during the filling procedure a filling opening (34) for the silicone gel lies on a lower end that is defined by means of gravity and a ventilation opening (36) lies on an upper end that is defined by means of gravity.

12. Method according to one of claims 9 to 11, moreover having the step:
arranging at least synthetic material film (48, 50) on the cladding part blank so as to close the recess (16), in particular a TPU film, wherein the synthetic material film (48, 50) is sealed so as to close the recess (16), in particular in the event of a vacuum, excess of pressure and/or under increased temperature.

13. Method according to one of claims 9 to 12, wherein
the cladding part blank comprises two sheets (42, 44) and the at least one solar cell (14) is arranged between said sheets, wherein the sheets (42, 44) are deformed.

14. Method according to claim 13, moreover comprising the steps:
- arranging a first synthetic material film (50) on a first side of a first sheet (42) of the two sheets;
- arranging the at least one solar cell (14) on the first synthetic material film (50);
- arranging a second synthetic material film (48) on the at least one solar cell (14) and/or the first synthetic material film (50);
- arranging the second sheet (44) on the second synthetic material film (48) and/or arranging the second synthetic material film (48) on the second sheet (44);
- connecting the first synthetic material film (50) to the second synthetic material film (48) to one another so as to close the at least one recess (16), in particular by means of autoclaving.

## Revendications

1. Pièce de carrosserie (12) d'un véhicule à moteur (10), pourvue d'au moins un élément de châssis (18) et d'au moins une pièce d'habillage (20) disposée sur ce dernier, la pièce d'habillage (20) comportant au moins un évidement (16) lequel est fermé de manière à être sensiblement étanche à l'air et sensiblement étanche à l'eau et dans lequel sont disposées plusieurs cellules solaires (14) rigides et planes qui sont connectées électriquement les unes aux autres afin de produire de l'énergie électrique,
et la face extérieure de la pièce d'habillage (20) ayant, au moins dans une zone adjacente à l'une des cellules solaires (14), une forme extérieure qui présente une courbure tridimensionnelle et qui est réalisée de manière à devenir, suite à son montage sur le véhicule à moteur (10), un élément constitutif du contour extérieur dudit véhicule,
**caractérisée en ce que**
ledit élément de châssis est un élément structurel porteur majeur de ladite pièce de carrosserie tout en servant, suite à son montage sur le véhicule à moteur, de support et de soutien à ladite pièce d'habillage, la pièce d'habillage n'étant ainsi qu'un élément structurel d'une importance relativement mineure.

2. Pièce de carrosserie (12) selon la revendication 1,
la face extérieure de la pièce d'habillage (20) étant disposée dans le prolongement d'une face extérieure de l'élément de châssis (18) de manière à se trouver sensiblement à fleur de cette dernière.

3. Pièce de carrosserie (12) selon l'une des revendications précédentes,
la pièce d'habillage (20) comprenant au moins un élément de support (38) dont au moins certaines parties présentent une courbure qui suit la courbure du contour extérieur et dans lequel ou sur lequel est disposée au moins une cellule solaire (14).

4. Pièce de carrosserie (12) selon la revendication 3,
l'élément de support (38) étant constitué d'un au moins deux vitres (42, 44), l'une (42) des vitres, en position extérieure, formant la face extérieure (44) de la pièce d'habillage (20) et l'une (42) des vitres, en position intérieure, formant une face intérieure située à l'opposé de ladite face extérieure, l'évidement (16) étant réalisé de manière à se trouver entre les deux vitres (42, 44).

5. Pièce de carrosserie (12) selon l'une des revendications 3 ou 4,
un espace libre, situé entre l'au moins une cellule solaire (14) et les parois correspondantes lesquelles appartiennent à la pièce d'habillage et délimitent l'évidement (16) associé, étant rempli d'un gel de silicone.

6. Pièce de carrosserie (12) selon l'une des revendications 3 à 5,
l'évidement (16) étant délimité par deux feuilles (48, 50), s'agissant notamment de feuilles en polyuréthanne thermoplastique, qui sont disposés sur l'élément de support (38) et reliées l'une à l'autre afin d'étanchéifier l'évidement (16).

7. Pièce de carrosserie (12) selon l'une des revendications précédentes,
l'élément de châssis (18) comportant une zone d'accueil pourvue d'un palier (22), la pièce d'habillage (20) étant disposée dans ladite zone d'accueil.

8. Pièce de carrosserie (12) selon la revendication 7,
le palier (22) de l'élément de châssis (18) étant réalisé sensiblement en forme de Z, une branche supérieure (28) du palier (22) en forme de Z constituant la face extérieure de l'élément de châssis (18) laquelle se situe sensiblement dans le prolongement de la pièce d'habillage (20) de manière à affleurer celle-ci, et une branche inférieure (24) du palier (22) constituant une surface sur laquelle repose la pièce d'habillage (20).

9. Procédé de fabrication d'une pièce de carrosserie (12) selon l'une des revendications 1 à 8, comprenant les étapes suivantes :
- mise à disposition d'une pièce d'habillage non-finie ;
- déformation de la pièce d'habillage non-finie ;
- réalisation d'au moins un évidement (16) lequel peut être fermé de manière à être sensiblement étanche à l'air et sensiblement étanche à l'eau et dans lequel sont disposées plusieurs cellules (14) solaires rigides et planes qui sont électriquement connectées les unes aux autres et qui permettent à la pièce de carrosserie (12) finie de produire de l'énergie électrique ;
- fermeture de l'au moins un évidement (16) de la pièce d'habillage non-finie, avec les cellules solaires (14) disposées dans ou sur cette dernière, afin de former une pièce d'habillage (20) finie ;
- mise à disposition d'un élément de châssis (18) comportant une zone d'accueil destinée à la pièce d'habillage (20) ;
- mise en place de la pièce d'habillage (20) dans la zone d'accueil de l'élément de châssis (18) ;
dans lequel une face extérieure de la pièce d'habillage (20) a, au moins dans une zone adjacente à l'une des cellules solaires (14), une forme extérieure qui présente une courbure tridimensionnelle et qui est réalisée de manière à devenir, suite à son montage sur le véhicule à moteur (10), un élément constitutif du contour extérieur dudit véhicule.

10. Procédé selon la revendication 9, comprenant en outre les étapes de :
- mise en place d'une pluralité de cellules solaires (14) sensiblement planes sur la pièce d'habillage non-finie au moyen d'un gabarit ;
- connexion électrique de la pluralité de cellules solaires (14), notamment par brasage.

11. Procédé selon l'une des revendications 9 ou 10, consistant à
remplir d'un gel de silicone un espace libre, situé entre l'au moins une cellule solaire (14) et les parois correspondantes lesquelles appartiennent à la pièce d'habillage (20) et délimitent l'évidement (16) associé, un orifice de remplissage (34) pour ledit gel de silicone étant de préférence situé à une extrémité inférieure définie par la gravité et un orifice d'évacuation d'air (36) étant de préférence situé à une extrémité supérieure définie par la gravité.

12. Procédé selon l'une des revendications 9 à 11, comportant en outre l'étape de :
mise en place d'au moins une feuille en matière plastique (48, 50) sur la pièce d'habillage non-finie afin de fermer l'évidement (16), s'agissant notamment d'une feuille en PU-T, la feuille en matière plastique (48, 50) étant notamment scellée sous l'effet d'une pression négative, d'une pression positive et/ou de la chaleur, pour ainsi fermer l'évidement (16).

13. Procédé selon l'une des revendications 9 à 12,
dans lequel la pièce d'habillage non-finie comporte deux vitres (42, 44) entre lesquelles est disposée l'au moins une cellule solaire (14) en soumettant les vitres (42, 44) à une mise en forme.

14. Procédé selon la revendication 13, comprenant en outre les étapes de :
- mise en place d'une première feuille en matière plastique (50) sur une première face de la première vitre (42) des deux vitres ;
- mise en place de l'au moins une cellule solaire (14) sur la première feuille en matière plastique (50) ;
- mise en place d'une deuxième feuille en matière plastique (48) sur l'au moins une cellule solaire (14) et/ou sur la première feuille en matière plastique (50) ;
- mise en place de la deuxième vitre (44) sur la deuxième feuille en matière plastique (48) et/ou mise en place de la deuxième feuille en matière plastique (48) sur la deuxième vitre (44) ;
- réalisation d'une liaison entre la première et la deuxième feuilles en matière plastique (48, 50), au moins sur certaines parties, pour ainsi fermer l'au moins un évidement (16), notamment par autoclavage.
